# EUROPEAN PATENT SPECIFICATION

(11) **EP 2 702 187 B1**
(45) Date of publication and mention of the grant of the patent: **14.11.2018**
(21) Application number: 11716575.3
(22) Date of filing: 29.04.2011
(51) Int. Cl.: C23C 14/58, C23C 14/56, C23C 14/20

(54) **DEVICES AND METHODS FOR PASSIVATING A FLEXIBLE SUBSTRATE IN A COATING PROCESS**
VORRICHTUNGEN UND VERFAHREN ZUR PASSIVIERUNG EINES FLEXIBLEN SUBSTRATS IN EINEM BESCHICHTUNGSVERFAHREN
DISPOSITIFS ET PROCÉDÉS POUR LA PASSIVATION D'UN SUBSTRAT SOUPLE DANS UN PROCÉDÉ D'APPLICATION DE REVÊTEMENT

(43) Date of publication of application: 05.03.2014
(60) Divisional application: 18196548.4
(73) Proprietor: Applied Materials, Inc., Santa Clara, CA 95054 (US)
(72) Inventor: HOFFMANN, Gerd, 63486 Bruchkoebel (DE); WOLFF, Alexander, 63755 Alzenau (DE)
(74) Representative: Zimmermann & Partner Patentanwälte mbB
(86) International application number: PCT/EP2011/056877
(87) International publication number: WO 2012/146310

(56) References cited:
- EP-A1- 0 555 518
- EP-A1- 0 775 758
- EP-A1- 1 400 990
- WO-A1-2008/076364
- US-A- 5 322 733

## Description

### FIELD OF THE INVENTION

Embodiments of the invention generally relate to devices in coating processes and to methods of passivating a coating of a flexible substrate. In particular, embodiments relate to devices and methods for passivating an aluminium coating of a web. Some embodiments relate to devices and methods for passivating an aluminium coating of a web in thin-film solar cell production, others to passivating an aluminium coating of a web in the production of flexible displays.

### BACKGROUND OF THE INVENTION

In apparatuses and methods for coating a flexible substrate such as a web in the production of thin-film solar cells a passivation of the flexible substrate is necessary. This may be due to the fact that the direct contact of a coated web with rollers on the side of the web that is already coated may harm the coating. The passivation protects the flexible substrate such that the flexible substrate can be guided by rollers on the coated side of the flexible substrate.

As a result, devices using passivation plasma reactors are used for the passivation of fresh coated Aluminium layers on flexible substrates to protect the coating. The passivation is prior to rewinding the flexible substrate onto a take-up roller. The passivation plasma reactor comprises a plasma treater and a gas source.

However, plasma treaters may be complex devices. For operating such devices a considerable amount of energy may be required.
Document US 5,993,622 discloses a crucible in a vacuum chamber that holds material to be evaporated, such as a metal or metal oxide or a mixture of a metal and a metal oxide, and a coating roll guides a film web a certain distance away from the material to be evaporated. A chamber is provided on each side of the coating roll which carries the film web past the crucible, a magnetron cathode connected to a medium-frequency source being provided in each chamber. Each of the two chambers is connected by its own channel to a coating zone directly between the coating roll and the crucible, and each chamber is connected by a pressure line to a source of process gas.
Document WO 2008/076364 A1 discloses a continuous in-vacuum process for the manufacture of a film metallized with aluminum, the aluminum layer is exposed to a passivating agent, inline, immediately after deposition and prior to rewinding of the film onto a take-up roller. Passivation is carried out by plasma treatment in an oxidizing atmosphere (oxygen, nitrogen or others). The resulting product exhibits no peel-off problems during unwinding of the take-up roller and greatly improved corrosion resistance.

### SUMMARY OF THE INVENTION

In light of the above, an apparatus for passivating a coating of a flexible substrate, and a method for passivating a coating of a flexible substrate as described herein are provided.

According to embodiments described herein, an apparatus for passivating a coating of a flexible substrate is provided. The apparatus comprises a coating chamber for coating the flexible substrate and a chamber separation element, the chamber separation element being arranged for separating the coating chamber from a further chamber, and comprising a shield arranged parallel to the surface of the coating drum. Furthermore, the apparatus comprises a coating drum, the coating drum and the chamber separation element forming a gap, wherein a gas inlet is arranged within the chamber separation element for supplying oxygen into the gap. The chamber separation element is arranged on an exit side of the coating drum. The gas inlet is arranged closer to the coating chamber than to the further chamber; and the gap length is at least ten times more than the gap width.

According to further embodiments described herein, a method for passivating a coating of a flexible substrate in an apparatus is provided. The apparatus comprises a coating chamber for coating the flexible substrate; a chamber separation element arranged on an exit side of the coating drum, the chamber separation element being arranged for separating the coating chamber from a further chamber; a coating drum, the coating drum and the chamber separation element includes a shield arranged parallel to the surface of the coating drum and forming a gap between the surface of the coating drum and the chamber separation element; and a gas inlet formed in the shield, the gas inlet being arranged within the chamber separation element. The gas inlet is arranged closer to the coating chamber than to the further chamber and the gap length is at least ten times more than the gap width. Oxygen is supplied through the gas inlet into the gap.

Further advantages, features, aspects and details that can be combined with the above embodiments are evident from the dependent claims, the description and the drawings.

Embodiments are also directed to apparatuses for carrying out each of the disclosed methods and include apparatus parts for performing each described method steps. These method steps may be performed by way of hardware components, a computer programmed by appropriate software, by any combination of the two or in any other manner. Furthermore, embodiments are also directed to methods by which the described apparatus operates or by which the described apparatus is manufactured. It includes method steps for carrying out functions of the apparatus or manufacturing parts of the apparatus.

### BRIEF DESCRIPTION OF THE DRAWINGS

So that the manner in which the above recited features of the present invention can be understood in detail, a more particular description of the invention, briefly summarized above, may be had by reference to embodiments. The accompanying drawings relate to embodiments of the invention and are described in the following:
Fig. 1 is a schematic sectional view of a typical embodiment with a gas inlet being arranged within a chamber separation element;
Fig. 2 is a schematic sectional view of a further typical embodiment with a further gas inlet being arranged within a further chamber separation element;
Fig. 3 is a schematic sectional view of a stacked arrangement of layers of a coating according to an embodiment; and
Fig. 4 is a schematic representation of a flow diagram of a method of an embodiment.

### DETAILED DESCRIPTION OF THE DRAWINGS

Reference will now be made in detail to the various embodiments of the invention, one or more examples of which are illustrated in the figures. Within the following description of the drawings, the same reference numbers refer to the same components. Generally, only the differences with respect to individual embodiments are described. Each example is provided by way of explanation of the invention and is not meant as a limitation of the invention. Further, features illustrated or described as part of one embodiment can be used on or in conjunction with other embodiments to yield yet a further embodiment. It is intended that the description includes such modifications and variations.

According to some embodiments, processes and apparatuses for passivating a coating on substrates, for example on flexible substrates, are provided. Thereby, flexible substrates can be considered to include inter alia films, foils, webs, strips of plastic material, metal or other materials. Typically, the terms "web", "foil", "strip", "substrate", "flexible substrate" and the like are used synonymously. According to some embodiments, components for passivating processes and apparatuses for passivating processes according to embodiments described herein can be provided for the above-described flexible substrates. However, they can also be provided in conjunction with non-flexible substrates such as glass substrates or the like, which are subject to the reactive deposition process from evaporation sources. In typical embodiments the passivation is carried out during the manufacture of a metalized film onto a flexible substrate. Typical flexible substrates may be webs, like a polymeric web. The polymeric web typically comprises polypropylene, polyethylene or polyester.

Typical first materials are metals or alloys comprising a metal. In typical embodiments aluminum or an aluminum alloy is used as the first material. The embodiments are described with reference to conventional inline vacuum deposition processes in which a coating of the first material is deposited on a flexible substrate. With embodiments described herein, aluminum layers can be passivated such that they do not stick on the rear side of the film when wound in a rewinder. The layer stack of the first material, e.g. aluminum and the passivated top layer provides a better barrier. The passivated top layer is very scratch resistant.

The term "passivation" refers to the process of treating a metallic material to passivate the uppermost layer. The passivation alters the susceptibility to corrosion or deterioration from exposure to environmental factors, especially moisture. For example, a protective layer on the metallic surface can comprise Al2O3 when aluminium is the material used for the coating. The protective layer is produced in the passivation process.

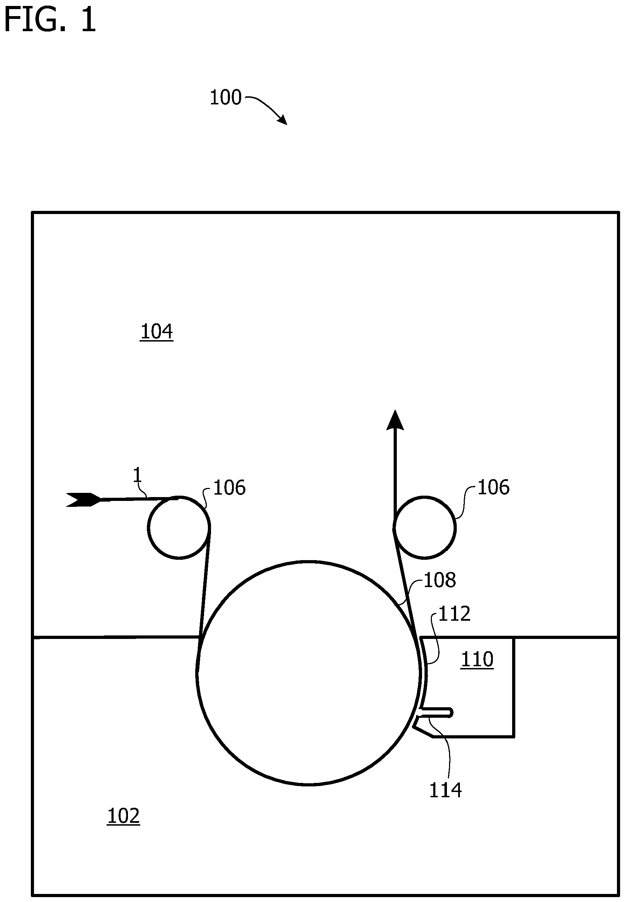

Fig. 1 shows an apparatus 100 for passivating a flexible substrate 1. The apparatus comprises a coating chamber 102 and a further chamber 104. The further chamber 104 is typically a winding chamber in which the flexible material can be wound up. The substrate 1 is guided by a plurality of guiding rollers 106 over a coating drum 108. According to typical embodiments, the substrate 1 is processed, e.g. coated, during its passage through the coating chamber 102 on the coating drum 108.

According to some embodiments described herein the further chamber serves as a supply chamber to supply the flexible material to the coating drum and for transporting the flexible material to further process devices. A guiding roller, also referred to as a feed roller, arranged in the further chamber is used to direct the flexible material to the coating drum.

A chamber separation element 110, such as a chamber separation bracket or a bended sheet, is arranged between the coating chamber 102 and the further chamber 104 for separating the coating chamber 102 from the further chamber 104. The chamber separation element 110 comprises a shield 112 which is arranged parallel to the surface of the coating drum 108 and forms a gap between the surface of the coating drum 108 and the chamber separation element 110. In the shield 112, an opening is present forming a gas inlet 114. The gas inlet 114 is arranged for directing oxygen into the gap. Further gases like inert gases such as argon can be added to the oxygen forming a gas mixture. Thereby, the amount of oxygen can be more easily controlled.

Typical embodiments described herein comprise at least one chamber separation element. Typical examples of a chamber separation element comprise a shield being arranged at least partly parallel to the surface of the coating drum, the shield forming the gap. In the shield, typically at least one opening is present forming the gas inlet. Some embodiments comprise a further shield in connection with the shield forming the gap. The further shield may form a guard for the gas inlet. The shield prevents the highly reactive evaporated first material from reaching parts of the gas inlet. In typical embodiments the chamber separation element is formed as a bracket, one part of the bracket forming a barrier towards the coating chamber and a further part of the bracket forming a barrier towards the further chamber. The effect is, that the gas inlet can be at least partly encapsulated in the chamber separation bracket shielding the gas inlet against highly reactive evaporated aluminum.

The chamber separation element of some typical embodiments described herein comprises or is made of sheet material or bended sheet material. The material used is typically a metal alloy or stainless steel. Thereby, a considerable protection of the gas inlet can be achieved.

The passivation of a first material like a metal layer is a typical step in the in-vacuum process of manufacture of metal films coated on flexible substrates in order to avoid damage of the coating comprising the metal film. Possible damages may include corrosion or peel-off of the coating. The peel-off may take place when the flexible substrate is unwound from a take up roller. The passivation is therefore typically carried out in a vacuum atmosphere before the flexible web is taken up by the take up roller.

Typical embodiments have a vacuum with a maximum pressure in the coating chamber of 0.01 mbar, 0.001 mbar or even with a maximum pressure of 0.0005 mbar. The minimum pressure in the coating chamber is typically 0.00001 mbar. In the further chamber, the pressure during operation is typically below 0.1 mbar or below 0.05 mbar. A different pressure between the coating chamber and the further chamber ensures that the supplied oxygen is urged in the gap in a direction towards the coating chamber. One effect is that the oxygen is brought in a region, where the uppermost material layers of the coating are highly reactive due to the fact that the build-up of these layers has just taken place or is even still in progress. Further devices like plasma sources, sputter cathodes or top coaters for enhancing the passivation of the first material are not necessary. Typical embodiments comprise an apparatus being plasma-source-free. Typical embodiments described herein do not need an additional energy source for the passivation process, only a simple supply of oxygen is needed. Energy savings can be achieved by omitting an oxygen-plasma device. The passivation is processed usually in an oxygen-plasma-free atmosphere, wherein oxygen is supplied without creating plasma.

The gas inlet 114 is formed in the shield 112 such that it is arranged in the gap nearer to the coating chamber than to the further chamber. The distance along the gap from the gas inlet 114 to the further chamber 104 is ten times as long as the distance to the coating chamber 102. Therefore, most of the oxygen is reaches the coating chamber, where the oxygen reacts with a vapor of the first material and a passivation layer is created.

In typical embodiments described herein, the distance along the gap from the gas inlet to the further chamber is at least five times, typically at least ten times or even at least fifteen times as long as the distance to the coating chamber. Thereby, the oxygen is supplied into a region towards the coating chamber where the first material, such as evaporated aluminum, is still highly reactive. Some of the embodiments described herein comprise a gap which is at least 5 cm long or at least 10 cm long, typically at least 15 cm long. The distance between the surface of the coating drum and the chamber separation element is typically at least 1 mm or at least 2 mm. The distance between the surface of the coating drum and the chamber separation element is typically not greater than 10 mm or not greater than 5 mm. A narrow gap supports a precise supply of the oxygen. Some embodiments described herein provide a gap having a length which is at least ten times, typically at least twenty times, as long as the gap width. Thereby, the oxygen is supplied target-orientated through the gas inlet.

In typical embodiments, a gas inlet is arranged in proximity of a coating drum to ensure a passivation of the coating before the flexible substrate reaches a guiding roller or another roller like a take up roller also referred to as a winding roller for winding up the flexible substrate. The term "in proximity of the coating drum" refers to an area nearby the coating drum, e.g. within a distance to the surface of the coating drum less than the radius of coating drum or less than 20% of the radius of the coating drum. A gas inlet nearby the coating drum enables a passivation of the first material shortly after or shortly before the deposition of the first material.

The substrate 1 is guided by one of the guiding rollers 106 towards the coating drum 108. It passes from the further chamber 104 into the coating chamber 102 touching the surface of the coating drum 108. On its passage through the coating chamber 102 the substrate 1 lays against the coating drum 108. In the coating chamber 102, the substrate 1 is coated with a first material like aluminum.

In typical embodiments described herein, the substrate is coated with a first material containing or consisting of aluminium. Other materials used typically as first material are tin, zinc, Iridium, Bismuth or silver. In typical embodiments, also alloys containing one or more of the named elements are used as first material.

During leaving the coating chamber 102, the substrate gets through the gap passing the gas inlet 114. In the vicinity of the gas inlet 114, the coating of the substrate 1 is passivated. After passivation the substrate gets into contact with the second one of the guiding rollers 106. Due to the passivation, no damage occurs to the substrate 1 when it touches the second one of the guiding rollers 106.

According to typical embodiments, a flexible substrate includes, but is not limited to a CPP film (i.e., a casting polypropylene film), an OPP film (i.e., an oriented polypropylene film), or a PET film (i.e., an oriented polyethylene terephthalate film). Alternatively, the flexible substrate may be a pre-coated paper, a polypropylene (PP) film, a PEN film, a poly lactase acetate (PLA) film, or a PVC film. According to typical embodiments, the flexible substrate has a thickness below 50 µm or more specifically 5 µm or even more specifically 2 µm. For example, the flexible substrate may be a 20 µm OPP substrate or a 12 µm PET substrate. Embodiments described herein also contemplates that the flexible substrate is an ultra thin film having a thickness of 2 µm or below, e.g., 0.7 µm. According to typical embodiments, the elements of the system are appropriately configured depending on the flexible substrate, so that the substrate can be processed as described herein. Flexible substrates like PET, OPP, CPP provide a good bonding between the layer of the first material, e.g. aluminum, and the substrate. A passivated layer can be used as adhesions promoter. For this purpose, the oxygen is supplied before or at the beginning of the coating process, e.g. at a chamber separation element at the entry side of the coating chamber.

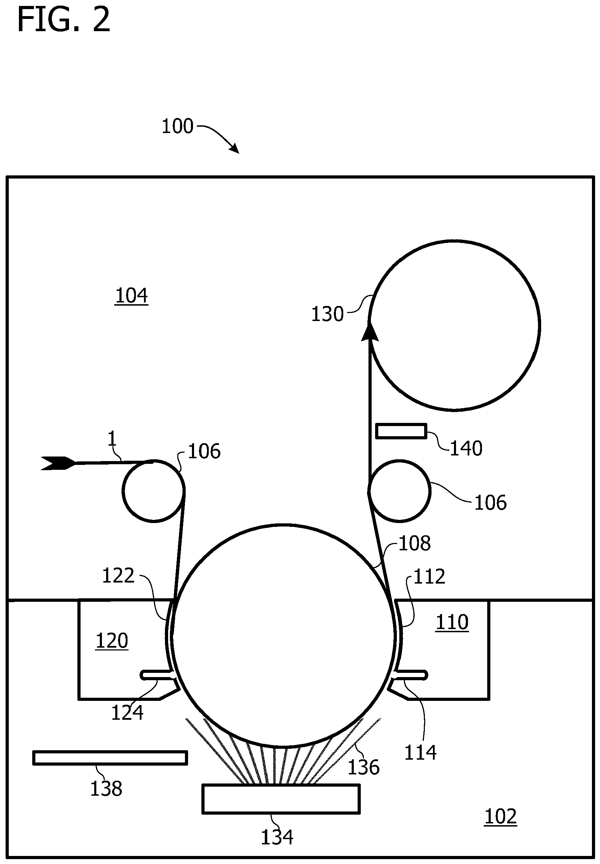

A further aspect of embodiments of the present invention is illustrated with respect to Fig. 2. As previously shown in Fig. 1, Fig. 2 shows an apparatus 100 for passivating a flexible substrate. However, the apparatus shown in Fig. 2 comprises additional features like a further chamber separation element 120. The further chamber separation element 120 is arranged between the coating chamber 102 and the further chamber 104. The further chamber separation element 120 is arranged mirrored to the first chamber separation element 120 on the opposite side of the coating drum 108.

The further chamber separation element 120 comprises a further shield 112 with a further gas inlet 124 being arranged in the further shield 112. The further chamber separation element 120 forms a further gap with the coating drum 108. By supplying oxygen to the further gas inlet 124, a passivation of the lower side of the coating on the substrate 1 is achieved.

The further chamber separation element is typically arranged like the chamber separation element. The above mentioned typical dimensions of the gap apply as well to the further gap. According to typical embodiments described herein, the further gas inlet is arranged nearer to the coating chamber than to the further chamber. Thereby, a delivery of oxygen into a region with highly reactive first material, like evaporated aluminium is achieved. Some embodiments described herein comprise a chamber separation element on the entry side of the coating drum. Some further embodiments described herein comprise a chamber separation element on the exit side of the coating drum. Even further embodiments comprise two chamber separation elements, one of which is located on the entry side and the other of which is located in the exit side. Thereby, a two-side passivation of the coating can be achieved. The layer stack with coating material being sandwiched by two passivation layers, e.g. AlOx-Al-AlOx, can be produced in only one coating chamber or coating zone at the same time and at high web speed. Herein, the expression "entry side" refers to the area where the substrate enters into the coating chamber, typically through a gap which may be formed by a chamber separation element and the coating drum. The expression "exit side" refers to the area where the substrate leaves the coating chamber, typically through a gap which may be formed by a chamber separation element and the coating drum.

According to typical embodiments, the passivation step comprising a supply of oxygen is carried out immediately after deposition of the first material onto the flexible substrate. Typically, oxygen can additionally be supplied immediately before deposition of the first material onto the flexible substrate to passivate a layer of the first material next to the flexible substrate. Supplying oxygen in the vicinity of the coating drum immediately before the coating step provides a passivated layer between the flexible substrate and the rest of the first material. By doing so, the bonding between the coating and the flexible material can be enhanced.

The apparatus 100 shown in Fig. 2 comprises a winding roller 130 in the further chamber. Therefore, the further chamber 104 can also be referred to as a winding chamber. The winding roller 130 takes up the substrate 1 after the substrate 1 has left the coating chamber 102 through the gap passing the gas inlet 114. Between the gap and the winding roller 130, the substrate passes one of the guiding rollers 106.

Typical embodiments described herein comprise a winding roller as winding device located in the further chamber. The further chamber can therefore be referred to as the winding chamber. The flexible substrate is rolled-up onto the winding roller for an easy handling of the flexible substrate after the coating process in the coating chamber.

In the exemplary embodiment shown in Fig. 2, an evaporation source 134 is provided for coating the flexible substrate 1 with a coating comprising the first material. The evaporation source produces an evaporation beam 136 directed towards the surface of the coating drum 108 with the flexible substrate 1. Thereby, evaporated first material is brought to the flexible substrate 1, such that the flexible substrate 1 is coated with the first material, e.g. aluminium. A moveable cover plate 138 can be moved over the evaporation source 134 for covering the evaporation source before starting the coating process. The cover plate 138 protects the coating drum 108 when no flexible substrate 1 is present on the surface of the coating drum 108.

Some embodiments described herein comprise a measurement device 140 for measuring the thickness of the passivation layer on the substrate 1. The measurement device 140 is typically arranged within the further chamber nearby the path of the substrate 1. Thereby a measured thickness of the passivation layer can be compared with a default thickness for adjusting the amount of oxygen supplied through the gas inlet 114.

According to different embodiments, which can be combined with any of the embodiments described herein, the coating can be a thermal evaporation or an electron beam evaporation. Coating unit may consist, for example, of staggered boat evaporators for facilitating an improved uniformity of the coated layer.

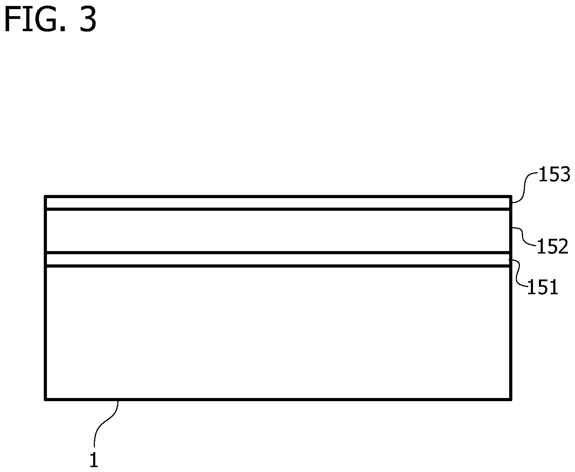

In Fig. 3, a schematic sectional view of a stacked arrangement of layers of a coating according to an embodiment is shown. The coating on the flexible substrate 1 comprises a first passivated layer 151 containing AlOx, a Al-layer 152, and a second passivated layer 153 containing AlOx. The first passivated layer 151 is adjacent to the flexible substrate 1 and can be referred to as a bonding layer which bonds the coating to the flexible substrate 1. The second passivated layer 153 protects the coating of the substrate 1. The substrate 1 of Fig. 3 can be produced with an apparatus according to the description in connection with Fig. 2 in only one coating process using only one coating chamber with a high band speed. Thereby, energy and time can be saved.

Typically, the first passivated layer is produced by supplying oxygen through the further gas inlet at the beginning of the coating zone such that oxygen is mixed into the vapor over the evaporation source. The second passivated layer is produced by supplying oxygen through the gas inlet at the end of the coating zone. In the middle of the coating zone, i.e. directly over the middle region of the evaporation source, pure first material, e.g. Al builds the middle layer of the stacked layer arrangement, e.g. AlOx-Al-AlOx.

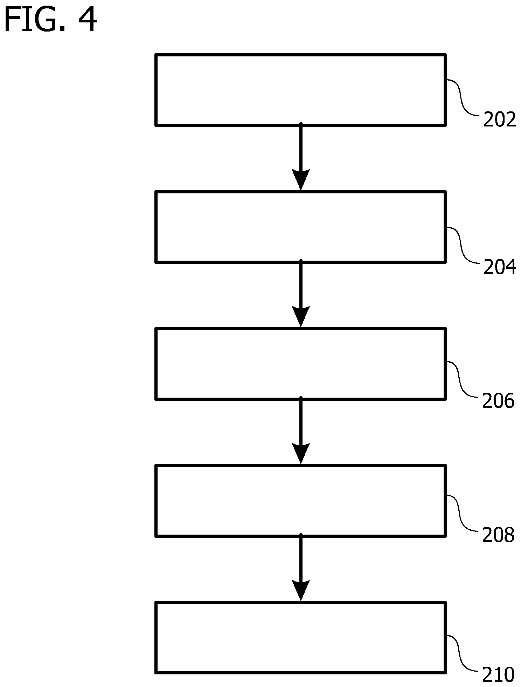

According to yet further embodiments, methods of operating an apparatus, particularly a method of passivating a coating are provided. An exemplary flow chart is shown schematically in Fig. 4. The exemplary method described herein is carried out with the apparatus shown in Fig 1. In step 202, a flexible substrate is brought into the coating chamber where material to be deposited on the substrate is evaporated. At the end of the coating zone the substrate enters into the gap between the chamber separation element and the coating drum. In step 204, oxygen is supplied through the gas inlet into the gap. Therefore, at the entry region at the beginning of the gap, the vapor of the first material, e.g. aluminum is mixed with the oxygen, such that a passivation layer, e.g. AlOx, is formed on the coating. In step 206 the flexible substrate leaves the gap and enters the further chamber. In step 208, the thickness of the passivation layer of the coating is measured with a measurement device. In step 210, the measured thickness is compared with a default thickness. In step 210, the amount of oxygen supplied through the gas inlet is controlled according to the comparison of the measured thickness and the default thickness. Thereby, a thickness of the passivation layer according to the default thickness can be ensured.

Exemplary embodiments of systems and methods for processing a substrate are described above in detail. The systems and methods are not limited to the specific embodiments described herein, but rather, components of the systems and/or steps of the methods may be utilized independently and separately from other components and/or steps described herein. For example, different combinations of web guiding rollers, such as STS rollers and spreader rollers, may be disposed upstream of the first roller and processing drum.

A vacuum chamber portion within the processing chamber may be provided with an entrance adapted for facilitating the introduction of substrate into the chamber while a vacuum condition is maintained therein. Alternatively, the entire roll-to-roll system, including unwinding and winding rollers, may be contained in vacuum chamber.

While the foregoing is directed to embodiments of the invention, other and further embodiments of the invention may be devised without departing from the basic scope thereof, and the scope thereof is determined by the claims that follow.

## Claims

1. Apparatus (100) for passivating a coating of a flexible substrate (1), comprising:
- a coating chamber (102) for coating the flexible substrate;
- a coating drum (108);
- a chamber separation element (110, 120), the chamber separation element being arranged for separating the coating chamber (102) from a further chamber (104), the chamber separation element (110) comprising a shield (112) arranged parallel to the surface of the coating drum (108) and forming a gap between the surface of the coating drum (108) and the chamber separation element (110);
- a gas inlet (114, 124) formed in the shield (112), the gas inlet being arranged within the chamber separation element (110, 120) for supplying oxygen into the gap,
wherein the chamber separation element (110, 220) is arranged on an exit side of the coating drum (102), and the gas inlet (114, 124) is arranged closer to the coating chamber (102) than to the further chamber (104); and
wherein the gap length is at least ten times more than the gap width.

2. Apparatus (100) of any of the proceeding claims, the gas inlet (114, 124) being arranged such that during operation stacked layers (151, 152, 153) comprising a layer of a first material and an oxide layer of the reactively oxidized first material are formed on the flexible substrate (1).

3. Apparatus (100) of any of the proceeding claims, the coating chamber (102) comprising a support for an evaporation source (134), the evaporation source providing vapor of the first material for coating the flexible substrate (1) in a deposition region of the coating drum (108), the deposition region being arranged adjacent to the chamber separation element (110, 120).

4. Apparatus (100) of any of the preceding claims, comprising a further chamber separation element (110, 120), the further chamber separation element (110, 120) being arranged between the coating chamber (102) and the further chamber (104), wherein a further gas inlet (114, 124) is arranged within the further chamber separation element (110, 120).

5. Apparatus (100) of claim 4, wherein the further chamber separation element (110, 120) is arranged on an entry side of the coating drum (108).

6. Apparatus (100) of claim 4, the coating drum (108) being arranged between the chamber separation element (110) and the further chamber separation element (120), the coating drum (108) and the further separation element (120) forming a further gap.

7. Apparatus (100) of any of the preceding claims, the gas inlet (114, 124) being arranged at least five times nearer to the coating chamber than to the further chamber (104).

8. Apparatus (100) of any of the preceding claims, the chamber separation element (110, 120) being formed as a bracket.

9. Apparatus (100) of any of the preceding claims, the further chamber (104) comprising a winding device for winding the flexible substrate (1).

10. Apparatus (100) of any of the preceding claims, the flexible material being a web.

11. A method for passivating a coating of a flexible substrate (1) in an apparatus (100) comprising a coating chamber (102) for coating the flexible substrate (1); a coating drum (108); a chamber separation element (110, 120) arranged on an exit side of the coating drum (102), the chamber separation element being arranged for separating the coating chamber (102) from a further chamber (104), the chamber separation element (110) comprising a shield (112) arranged parallel to the surface of the coating drum (108) and forming a gap between the surface of the coating drum (108) and the chamber separation element (110); and a gas inlet formed in the shield (112), the gas inlet (114, 124) being arranged within the chamber separation element (110, 120),
wherein the gas inlet (114, 124) is arranged closer to the coating chamber (102) than to the further chamber (104) and the gap length is at least ten times more than the gap width, the method comprising:
- supplying oxygen through the gas inlet into the gap (204) in an oxygen-plasma-free atmosphere.

12. Method of claim 11, further comprising the steps of
- evaporating a first material from an evaporation source (134) for coating the flexible substrate (1) in a deposition region of the coating drum, the deposition region being arranged adjacent to the chamber separation element (110, 120).

13. Method of claim 11 or 12, further comprising the steps of
- determining (208) the thickness of the formed oxide layer of reactively oxidized first material on the flexible substrate;
- comparing (210) the determined thickness with a default thickness; and
- controlling (210) the amount of oxygen supplied to the gas inlet.

14. Method of any of claims 11 to 13, the first material comprising aluminium.

## Patentansprüche

1. Vorrichtung (100) zum Passivieren einer Beschichtung eines flexiblen Substrats (1), umfassend:
- eine Beschichtungskammer (102) zum Beschichten des flexiblen Substrats;
- eine Beschichtungstrommel (108);
- ein Kammertrennelement (110, 120), wobei das Kammertrennelement zum Trennen der Beschichtungskammer (102) von einer weiteren Kammer (104) angeordnet ist, wobei das Kammertrennelement (110) einen Schirm (112) umfasst, der parallel zu der Oberfläche der Beschichtungstrommel (108) angeordnet ist und einen Spalt zwischen der Oberfläche der Beschichtungstrommel (108) und dem Kammertrennelement (110) formt;
- einen Gaseinlass (114, 124), der in dem Schirm (112) gebildet ist, wobei der Gaseinlass innerhalb des Kammertrennelements (110, 120) zum Liefern von Sauerstoff in den Spalt angeordnet ist,
wobei das Kammertrennelement (110, 120) an einer Austrittseite der Beschichtungstrommel (102) angeordnet ist und der Gaseinlass (114, 124) näher zu der Beschichtungskammer (102) als zu der weiteren Kammer (104) angeordnet ist; und
wobei die Spaltlänge mindestens zehnmal größer ist als die Spaltbreite.

2. Vorrichtung (100) nach einem der vorhergehenden Ansprüche, wobei der Gaseinlass (114, 124) so angeordnet ist, dass während des Betriebs gestapelte Schichten (151, 152, 153), die eine Schicht aus einem ersten Material und eine Oxidschicht des reaktiv oxidierten ersten Materials umfassen, auf dem flexiblen Substrat (1) gebildet werden.

3. Vorrichtung (100) nach einem der vorhergehenden Ansprüche, wobei die Beschichtungskammer (102) einen Träger für eine Verdampfungsquelle (134) umfasst, wobei die Verdampfungsquelle Dampf des ersten Materials zum Beschichten des flexiblen Substrats (1) in einer Abscheidungsregion der Beschichtungstrommel (108) bereitstellt, wobei die Abscheidungsregion neben dem Kammertrennelement (110, 120) angeordnet ist.

4. Vorrichtung (100) nach einem der vorhergehenden Ansprüche, ferner ein weiteres Kammertrennelement (110, 120) umfassend, wobei das weitere Kammertrennelement (110, 120) zwischen der Beschichtungskammer (102) und der weiteren Kammer (104) angeordnet ist, wobei ein weiterer Gaseinlass (114, 124) innerhalb des weiteren Kammertrennelements (110, 120) angeordnet ist.

5. Vorrichtung (100) nach Anspruch 4, wobei das weitere Kammertrennelement (110, 120) an einer Eintrittseite der Beschichtungstrommel (108) angeordnet ist.

6. Vorrichtung (100) nach Anspruch 4, wobei die Beschichtungstrommel zwischen dem Kammertrennelement (110) und dem weiteren Kammertrennelement (120) angeordnet ist, wobei die Beschichtungstrommel (108) und das weitere Trennelement (120) einen weiteren Spalt bilden.

7. Vorrichtung (100) nach einem der vorhergehenden Ansprüche, wobei der Gaseinlass (114, 124) zumindest fünfmal näher zu der Beschichtungskammer als zu der weiteren Kammer (104) angeordnet ist.

8. Vorrichtung (100) nach einem der vorhergehenden Ansprüche, wobei das Kammertrennelement (110, 120) als Halterung gebildet ist.

9. Vorrichtung (100) nach einem der vorhergehenden Ansprüche, wobei die weitere Kammer (104) eine Wickelvorrichtung zum Wickeln des flexiblen Substrats (1) umfasst.

10. Vorrichtung (100) nach einem der vorhergehenden Ansprüche, wobei das flexible Material eine Bahn ist.

11. Verfahren zum Passivieren einer Beschichtung aus eines flexiblen Substrats (1) in einer Vorrichtung (100), umfassend eine Beschichtungskammer (102) zum Beschichten des flexiblen Substrats; eine Beschichtungstrommel (108); ein Kammertrennelement (110, 120), das auf einer Austrittseite der Beschichtungsdtrommel (102) angeordnet ist, wobei das Kammertrennelement zum Trennen der Beschichtungskammer (102) von einer weiteren Kammer (104) angeordnet ist, wobei das Kammertrennelement (110) einen Schirm (112) umfasst, der parallel zu der Oberfläche der Beschichtungstrommel (108) angeordnet ist und einen Spalt zwischen der Oberfläche der Beschichtungstrommel (108) und dem Kammertrennelement (110) formt; und ein Gaseinlass, der in dem Schirm (112) gebildet ist, wobei der Gaseinlass (114, 124) innerhalb des Kammertrennelements (110, 120) angeordnet ist,
wobei der Gaseinlass (114, 124) näher zu der Beschichtungskammer (102) als zu der weiteren Kammer (104) angeordnet ist; und die Spaltlänge mindestens zehnmal größer ist als die Spaltbreite, wobei das Verfahren Folgendes umfasst:
- das Liefern von Sauerstoff durch den Gaseinlass in den Spalt (204) in einer sauerstoff-plasmafreien Atmosphäre.

12. Verfahren nach Anspruch 11, ferner die Schritte umfassend des
- Verdampfens des ersten Materials aus einer Verdampfungsquelle (134) zum Beschichten des flexiblen Substrats (1) in einer Abscheidungsregion der Beschichtungstrommel, wobei die Abscheidungsregion neben dem Kammertrennelement (110, 120) angeordnet ist.

13. Verfahren nach Anspruch 11 oder 12, ferner die Schritte umfassend
- Bestimmen (208) der Dicke der gebildeten Oxidschicht des reaktiv oxidierten ersten Materials auf dem flexiblen Substrat;
- Vergleichen (210) der bestimmten Dicke mit einer Standarddicke; und
- Regulieren (210) der Menge an Sauerstoff, die zu dem Gaseinlass geliefert wird.

14. Verfahren nach einem der Ansprüche 11 bis 13, wobei das erste Material Aluminium umfasst.

## Revendications

1. Appareil (100) destiné à la passivation d'un revêtement d'un substrat flexible (1), comprenant :
- une chambre de revêtement (102) pour le revêtement du substrat flexible ;
- un tambour de revêtement (108) ;
- un élément de séparation de chambre (110, 120), l'élément de séparation de chambre étant agencé pour la séparation de la chambre de revêtement) 102) à partir d'une chambre supplémentaire (104), l'élément de séparation de chambre (110) comprenant un écran (112) agencé de manière parallèle à la surface du tambour de revêtement (108) et formant une fente entre la surface du tambour de revêtement (108) et l'élément de séparation de chambre (110) ;
- une entrée de gaz (114, 124) formée dans l' écran (112), l'entrée de gaz étant agencée à l'intérieur de l'élément de séparation de chambre (110, 120) pour fournir de l'oxygène dans la fente,
dans lequel l'élément de séparation de chambre (110, 120) est agencé sur un côté de sortie du tambour de revêtement (102), et l'entrée de gaz (114, 124) est agencée de manière plus proche de la chambre de revêtement (102) que de la chambre supplémentaire (104) ; et
dans lequel la longueur de fente est au moins dix fois la largeur de fente.

2. Appareil (100) selon l'une quelconque des revendications précédentes, l'entrée de gaz (114, 124) étant agencée de sorte que pendant le fonctionnement des couches empilées (151, 152, 153) comprenant une couche d'un premier matériau et une couche d'oxyde du premier matériau oxydé de manière réactive sont formées sur le substrat flexible (1).

3. Appareil (100) selon l'une quelconque des revendications précédentes, la chambre de revêtement (102) comprenant un support pour une source d'évaporation (134), la source d'évaporation fournissant de la vapeur du premier matériau pour le revêtement du substrat flexible (1) dans une région de dépôt du tambour de revêtement (108), la région de dépôt étant agencée de manière adjacente à l'élément de séparation de chambre (110, 120).

4. Appareil (100) selon l'une quelconque des revendications précédentes, comprenant un élément supplémentaire de séparation de chambre (110, 120), l'élément supplémentaire de séparation de chambre (110, 120) étant agencé entre la chambre de revêtement (102) et la chambre supplémentaire (104), dans lequel une entrée supplémentaire de gaz (114, 124) est agencée à l'intérieur de l'élément supplémentaire de séparation de chambre (110, 120).

5. Appareil (100) selon la revendication 4, dans lequel l'élément supplémentaire de séparation de chambre (110, 120) est agencé sur un côté d'entrée du tambour de revêtement (108).

6. Appareil (100) selon la revendication 4, dans lequel le tambour de revêtement (108) est agencé entre l'élément de séparation de chambre (110) et l'élément supplémentaire de séparation de chambre (120), le tambour de revêtement (108) et l'élément supplémentaire de séparation (120) formant une fente supplémentaire.

7. Appareil (100) selon l'une quelconque des revendications précédentes, l'entrée de gaz (114, 124) est agencée au moins cinq fois plus près de la chambre de revêtement que de la chambre supplémentaire (104).

8. Appareil (100) selon l'une quelconque des revendications précédentes, l'élément de séparation de chambre (110, 120) étant formé comme un crampon.

9. Appareil (100) selon l'une quelconque des revendications précédentes, la chambre supplémentaire (104) comprenant un dispositif de bobinage destiné à l'enroulement du substrat flexible (1).

10. Appareil (100) selon l'une quelconque des revendications précédentes, le matériau flexible étant un lé.

11. Procédé destiné à la passivation d'un revêtement d'un substrat flexible (1) dans un appareil (100) comprenant une chambre de revêtement (102) destinée au revêtement du substrat flexible (1) ; un tambour de revêtement (108) ; un élément de séparation de chambre (110, 120) agencé sur un côté de sortie du tambour de revêtement (102), l'élément de séparation de chambre étant agencé pour la séparation de la chambre de revêtement (102) d'une chambre supplémentaire (104), l'élément de séparation de chambre (110) comprenant un écran (112) agencé de manière parallèle à la surface du tambour de revêtement (108) et formant une fente entre la surface du tambour de revêtement (108) et l'élément de séparation de chambre (110) ; et une entrée de gaz formée dans le écran (112), l'entrée de gaz (114, 124) étant agencée à l'intérieur de l'élément de séparation de chambre (110, 120),
dans lequel l'entrée de gaz (114, 124) est agencé de manière plus proche de la chambre de revêtement (102) que de la chambre supplémentaire (104) et la longueur de fente est au moins dix fois la largeur de fente, le procédé comprenant :
- la fourniture d'oxygène à travers l'entrée de gaz dans la fente (204) dans une atmosphère exempte de plasma d'oxygène.

12. Procédé selon la revendication 11, comprenant en outre les étapes de
- évaporation d'un premier matériau à partir d'une source d'évaporation (134) destinée au revêtement du substrat flexible (1) dans une région de dépôt du tambour de revêtement, la région de dépôt étant agencée de manière adjacente à l'élément de séparation de chambre (110, 120).

13. Procédé selon la revendication 11 ou la revendication 12, comprenant en outre les étapes de
- détermination (208) de l'épaisseur de la couche d'oxyde formée du premier matériau oxydé de manière réactive sur le substrat flexible ;
- la comparaison (210) de l'épaisseur déterminée avec une épaisseur par défaut ; et
- la commande (210) de la quantité d'oxygène fournie à l'entrée de gaz.

14. Procédé selon l'une quelconque des revendications 11 à 13, le premier matériau comprenant de l'aluminium.
